# EUROPEAN PATENT APPLICATION

(11) **EP 4 460 158 A1**
(43) Date of publication of application: **06.11.2024**
(21) Application number: 23170940.3
(22) Date of filing: 02.05.2023
(51) Int. Cl.: H05K 5/00

(54) **HOUSING FOR AN ELECTRONIC CIRCUITRY ASSEMBLY**

(71) Applicant: Veoneer Sweden Safety Systems AB, 10302 Stockholm (SE)
(72) Inventor: LETUVE, Jeremy, 95800 Cergy-Pontoise (FR)
(74) Representative: Reichert & Lindner Partnerschaft Patentanwälte

(57) **Abstract**

A housing (3) for an electronic circuitry assembly (1) is defined by a housing cover (4) and a base plate (6). The base plate (6) has at least two outer reinforcement ribs (9) at an inner surrounding rim (10). A surrounding sidewall (5) of the housing cover (4) sits with a free end (8) of the surrounding sidewall (5) on the base plate (6) between the at least two outer reinforcement ribs (9) and the inner surrounding rim (10), thereby defining a gap (7) between the free end (8) of the surrounding sidewall (5) on the base plate (6). A plurality of openings (11) is formed in the base plate (6). The openings (11) are placed between the at least two outer reinforcement ribs (9) and the inner surrounding rim (10) of the base plate (6). The free end (8) of the surrounding sidewall (5) covers the openings (11) at least partially.

## Description

### FIELD OF THE INVENTION

The invention relates to a housing for an electronic circuitry assembly. In particular, the invention relates to a housing for an electronic circuitry assembly being defined by a housing cover and a base plate, the base plate having at least two outer reinforcement ribs at an inner surrounding rim, a surrounding sidewall of the housing cover sitting with a free end of the surrounding sidewall on the base plate between the at least two outer reinforcement ribs and the inner surrounding rim, thereby defining a gap between the free end of the surrounding sidewall on the base plate.

### DESCRIPTION OF THE BACKGROUND ART

Electronic control units (ECUs) today consist of a housing and a base plate that are assembled. These ECUs are often subject to waterproofness requirements from customers, for example IPx3, which is a water aspersion test with water jets, as ECUs must also be waterproof in later use. There is usually a gap between the housing and the base plate to compensate for manufacturing tolerances. Water can flow through the gap between the housing and the base plate into the ECU. Therefore, water ingress problems can occur with this conventional construction design, as water accumulates between the base plate and the housing during IPx3 water testing. Water accumulates on the top side of the base plate because it cannot drain away quickly enough. A lake of water forms which cannot escape. Due to the natural effect of "capillarity", the water "climbs" between the housing and the base plate, i.e. the water level rises all around the ECU until it reaches the electronics of the ECU, e.g. a printed circuit board (PCB), and water eventually enters the control unit, causing damage to the electronics (short circuits, failures).

### SUMMARY OF THE INVENTION

It is an object of the present invention to provide a housing for an electronic circuitry assembly, which housing provides protection of the electronic circuitry assembly from possible water ingress and can be mounted to a body part of the electronic circuitry assembly.

The above object is achieved by a housing for an electronic circuitry assembly according to the features of claim 1.

In an embodiment of the housing for an electronic circuitry assembly, the housing is defined by a housing cover and a base plate. The base plate has at least two outer reinforcement ribs at an inner surrounding rim. A surrounding sidewall of the housing cover sits with a free end of the surrounding sidewall on the base plate between the at least some two outer reinforcement ribs and the inner surrounding rim, thereby defining a gap between the free end of the surrounding sidewall on the base plate. A plurality of openings is formed in the base plate. The openings are placed between the at least two outer reinforcement ribs and the inner surrounding rim of the base plate. The free end of the surrounding sidewall covers the openings at least partially.

The advantage of such a housing is that the openings in the base plate prevent water from accumulating on the top side of the base plate, since the water can discharge through the openings. Thus, the housing provides protection of the electronic circuitry assembly from possible water ingress and can be mounted to a body part of the electronic circuitry assembly.

In an embodiment of the housing, the openings are distributed around the inner surrounding rim of the base plate.

In an embodiment of the housing, the free end of the surrounding sidewall has a peripheral profile. The peripheral profile may be plain or have a groove formed therein. The openings may be formed by a punching process.

The openings may have an oblong form, a rectangular form, or a round form.

In an embodiment of the housing, the electronic circuitry assembly is an electronic control unit (ECU). It is obvious to a person skilled in the art that the present invention is not limited to a housing for an ECU as an electronic circuitry assembly.

### BRIEF DESCRIPTION OF THE DRAWINGS

The numerous advantages of the disclosure may be better understood by those skilled in the art by reference to the accompanying figures in which:
**Figure 1** shows a perspective and partially cut away view of a prior art assembly of housing for an ECU.
**Figure 2** is a detailed perspective view of the mount of the housing cover to the base plate of Fig. 1.
**Figure 3** shows a detailed perspective view of a water accumulation on the top side of the prior art base plate of Fig. 1.
**Figure 4** shows a perspective sectional view of the water ingress into the prior art housing of Fig. 1.
**Figure 5** shows a perspective top view of the prior art base plate of Fig. 1.
**Figure 6** shows a perspective top view of an embodiment of the base plate with oblong openings according to the present invention.
**Figure 7** is a top view of the embodiment shown in Fig. 6.
**Figure 8** is a sectional view of of the openings shown in Fig. 7 and the related water flow through the opening.
**Figure 9** shows a top view of an oblong profile of the opening of Figs. 6 to 8.
**Figure 10** shows a top view of another embodiment of the opening having a rectangular profile according to the present invention.
**Figure 11** shows another embodiment of the base plate with round openings according to the present invention.
**Figure 12** is a sectional view of one of the round openings shown in Fig. 11 and the associated water discharge through the round opening.
**Figure 13** is a sectional view of an embodiment showing the positioning of a free end of the sidewall of the housing cover and an opening in the base plate.
**Figure 14** is a sectional view of a further embodiment of the free end of the sidewall of the housing cover which is positioned in relation to an opening in the base plate.

### DETAILED DESCRIPTION

In the ensuing description, numerous specific details are provided to enable maximum understanding of the embodiments that are provided by way of example.

The embodiments may be implemented with or without specific details, or else with other methods, components, materials, etc. In other circumstances, well-known structures, materials, or operations are not illustrated or described in detail so that various aspects of the embodiments will not be obscured. Reference in the course of the present description to "an embodiment" or "one embodiment" means that a particular structure, peculiarity, or characteristic described in connection with its implementation is comprised in at least one embodiment. Hence, phrases such as "in an embodiment" or "in one embodiment" that may recur in various points of the present description do not necessarily refer to one and the same embodiment. Furthermore, the particular structures, peculiarities, or characteristics may be combined in any convenient way in one or more embodiments.

Same reference numerals refer to same elements or elements of similar function throughout the various figures. Furthermore, only reference numerals necessary for the description of the respective figure are shown in the figures. The shown embodiments represent only examples of how the invention can be carried out. This should not be regarded as a limitation of the invention.

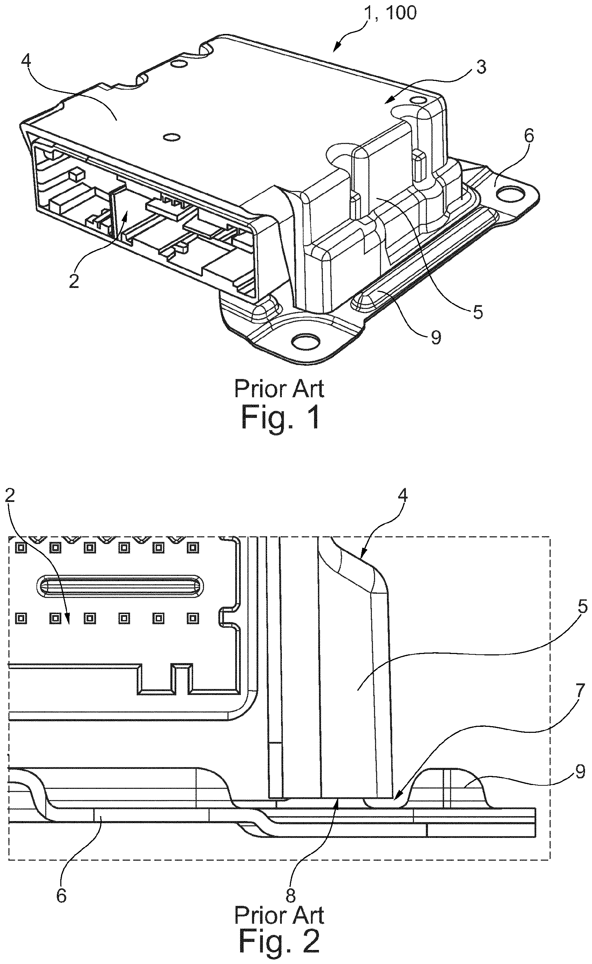

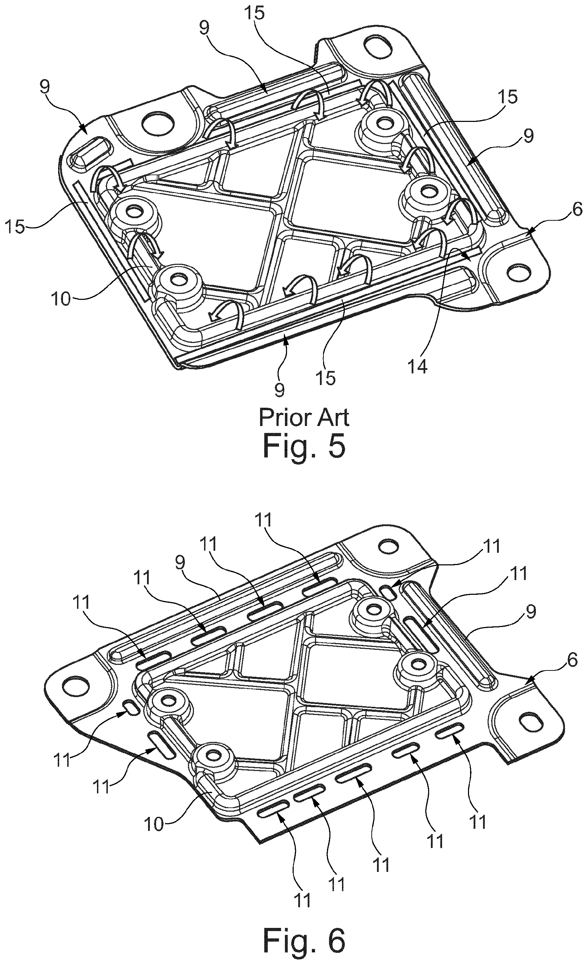

**Figure 1** shows a perspective and partially cut away view of a prior art assembly of a housing **3** for an ECU **100.** It is obvious to a person skilled in the art that the housing **3** may be used not only for an ECU **100** as an electronic circuitry assembly, but also for other types of electronic circuitry assemblies. The present invention (see Fig. 6 ff) is applicable to any housing **3** which requires protection of an electronic circuitry assembly **1** from water ingress and can be mounted to a body part (not shown) of the electronic circuitry assembly **1.** Housing **3** is defined by a housing cover **4** and a base plate **6.** Housing cover **4** rests on base plate **6,** and base plate 6 has at least two outer reinforcement ribs **9.**

**Figure 2** is a detailed perspective view of housing cover **4,** which is mounted to base plate **6** to form housing **3,** as shown in Fig. 1. Housing cover **4** has a surrounding sidewall **5** which forms a gap **7** in the mounted state between surrounding sidewall **5** of housing **3** and base plate **6** of housing **3.** Gap **7** is used to compensate for manufacturing tolerances.

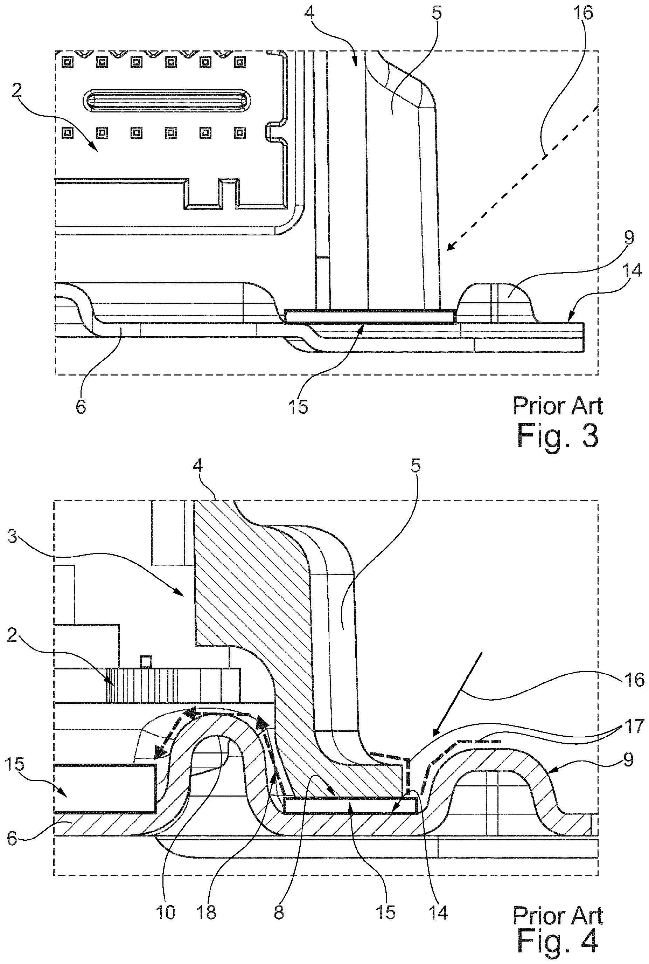

**Figure 3** shows a detailed perspective view of an accumulation of water **15** on the top side **14** of base plate **6** of prior art housing **3,** as shown in Fig. 1. The conventional housing **3,** defined by the assembled housing cover **4** and the base plate **6,** is subject to water ingress problems. During the water testing process, in which water jets **16** are directed onto base plate **6,** water **15** accumulates on top side **14** of base plate **6.** Water **15** accumulates on top side **14** because it cannot drain away quickly enough. Thus, the water level around housing cover **4** all around the ECU **100** rises and can reach electronics **2** enclosed by housing cover **4** and base plate **6** (see Fig. 4 for more details).

**Figure 4** shows a perspective sectional view of the water ingress into housing **3** of prior art. During the water testing process, water flows **17** are directed onto the top side **14** of base plate **6.** The water **15** collects between the free end **8** of sidewall **5** and the top side **14** of base plate **8** and is confined between the inner surrounding rim **10** and the outer reinforcement rib **9.** The natural effect of a capillary effect **18** causes the water **15** to climb and rise between the housing **3** and the base plate **6** and above the inner surrounding rim **10** to the base plate **6.** The level of water **15** inside inner surrounding rim **10** may rise until it reaches the electronics **2,** which may include a printed circuit board (PCB) and electrical pins. A lake of water **15** forms between the inner surrounding rim **10** and the outer reinforcement rib **9,** and the water **15** cannot escape. Water **15** then flows through gap **7** between housing **3** and base plate **6** further into the ECU **100** and can here reach the electronics **2** enclosed by housing cover **4** and base plate **6.** The water **15** may cause damages to the electronics **2,** for example short-circuits and/or other failures.

**Figure 5** shows a perspective top view of the prior art base plate **6,** the arrows showing the flow and ingress of water **15** into an area inside the inner surrounding rim **10.** The water **15** collects primarily outside the inner surrounding rim **10** and partially between the outer reinforcement ribs **9** and the inner surrounding rim **10.** The reinforcement ribs **9** of base plate **6** act as a barrier to trap the water **15.** However, the reinforcement ribs **9** are necessary for the base plate **6** to have an acceptable rigidity. Described below is the idea of the invention that while water **15** cannot be prevented from reaching this interface between the housing **3** and the base plate **6,** the water can be "helped" to escape more quickly to prevent accumulation.

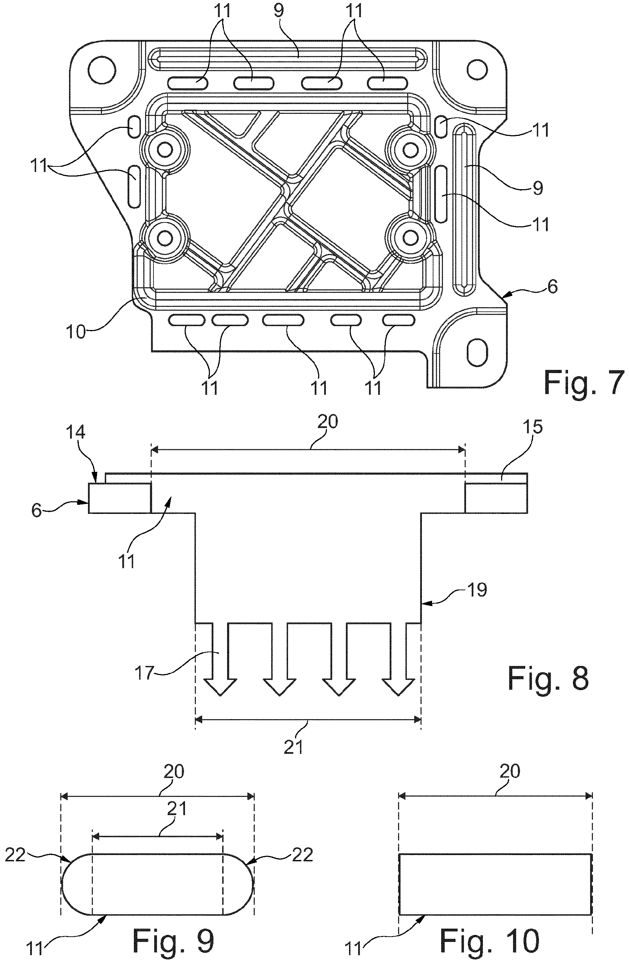

**Figure 6** shows a perspective top view of an embodiment of the base plate **6,** and **Figure 7** shows a top view of this embodiment according to the present invention. Note that it is obvious to a person skilled in the art that the present invention is not limited to a housing **3** for an ECU **100** (see Fig. 1) as an electronic circuitry assembly. Therefore, the present invention is applicable to any housing **3** which requires protection of an electronic circuitry assembly **1** (e.g., ECU **100**) from water ingress and can be mounted to a body part (not shown) of the electronic circuitry assembly **1.** According to this embodiment of the present invention, oblong openings **11** are formed in base plate **6.** The oblong openings **11** surround the inner surrounding rim **10** and are partially formed between the outer reinforcement ribs **9** and the inner surrounding rim **10.** The oblong openings **11** do not necessarily have the same length **20** (see Fig. 8). The length **20** may vary based on the position of the openings **11** on base plate **6.**

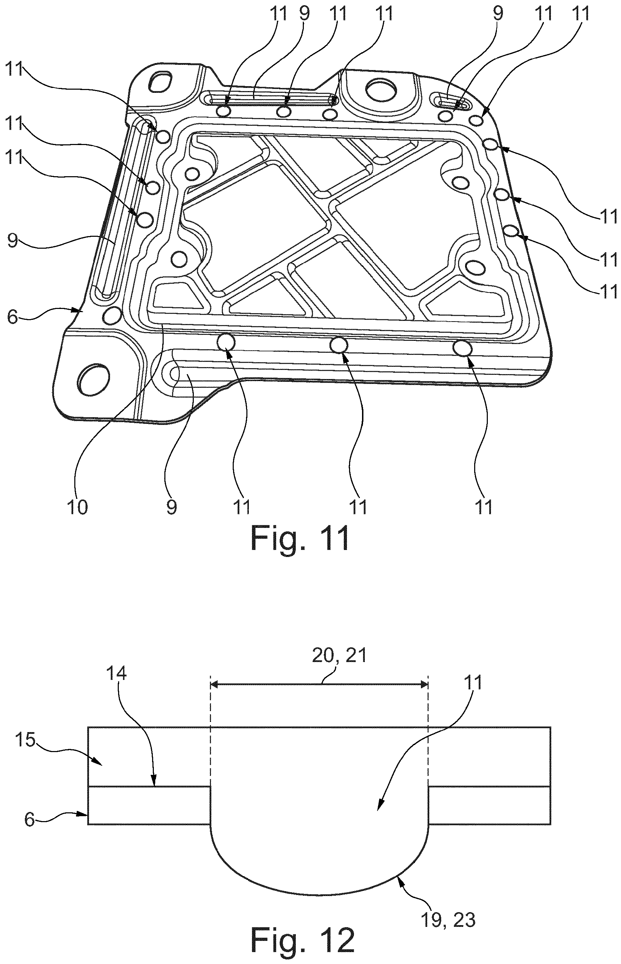

**Figure 8** is a sectional view of one of the openings **11** shown in Fig. 7 and the associated water flow **17** through the opening **11.** The openings **11** shown in Fig. 6 and Fig. 7 have an oblong form. The oblong openings **11** prevent water **15** from accumulating on the top side **14** of base plate **6.** The oblong openings **11** have a length **20** and an effective length **21.** The effective length **21** of the oblong openings **11** does not include the rounded end shapes **22** (see Fig. 9) of the oblong openings **11.** Because of the effective length **21** of the oblong openings **11,** surface tension does not build up, and water discharge **19** through the oblong openings **11** results in a nearly continuous flow of water **15.** Oblong openings **11** prevent the water **15** from forming "plugs" in the oblong openings **11,** unlike the classic round opening **11** (see Fig. 11 and 12). As a result, water **15** has no other choice but rather quickly fall downwardly through the oblong openings **11,** and thus water **15** does not have time to accumulate onto the base plate **6,** so that the water level does not rise too much and the water **15** cannot flow into the ECU **100.**

**Figure 9** shows a top view of an oblong profile of the opening **11** of Figs. 6 to 8. As mentioned above, a single oblong opening **11** has rounded end shapes **22** defining the longer length **20** and the shorter effective length **21.**

**Figure 10** shows a top view of another embodiment of the opening **11** having a rectangular profile according to the present invention. The rectangular openings **11** further increase the water discharge **19** because the influence of surface tension is further reduced, and the length **20** of the opening **11** is effective for the water discharge **19.**

**Figure 11** shows another embodiment of the base plate **6** with round openings **11** according to the present invention. The round openings **11** are formed in the base plate **6** and surround the inner surrounding rim **10.** The openings **11** are formed between the outer reinforcement ribs **9** and the inner surrounding rim **10.** **Figure 12** shows a sectional view of one of the round openings **11** of Fig. 11 and the associated water discharge **19** through the round opening **11.** The round opening **11** defines a diameter **20.** Here, the round openings **11** tend to trap the water **15** for a relatively long time (compared to oblong or rectangular openings **11**) due to surface tension, allowing a drop **23** to form substantially below the opening **11** before the water drop **23** drops overcomes the water surface tension due to its weight and falls. The water drop **23** acts like a "plug" (natural phenomenon), so that the formation of the water drop **23** gives the water **15** time to accumulate on the top side **14** of base plate **6** and the water **15** can climb up to the PCB and flow inside the ECU **100.** Hence, compared to the embodiments of the openings **11** with oblong or rectangular openings **11** shown in Fig. 9 and Fig. 10, the water discharge **19** through round openings **11** acts only dropwise and is weak, and the water **15** accumulates at a greater level on the base plate **6** with the round openings **11** in Figs. 11 and 12.

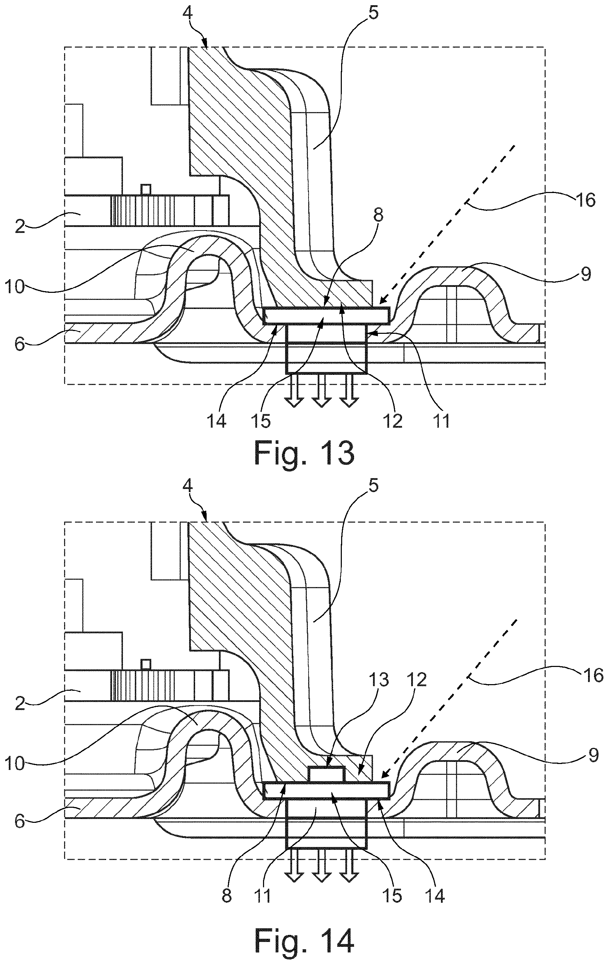

**Figure 13** is a sectional view of an embodiment showing the positioning of a free end **8** of the sidewall **5** of housing cover **4.** The free end **8** is positioned opposite to the top side **14** of base plate **6,** which is located between the outer reinforcement ribs **9** and the inner surrounding rim **10.** The free end **8** defines a peripheral profile **12** which has a flat form and is positioned largely above the opening **11** in the base plate **6.** The applied water jet **16** causes water **15** to accumulate on the top side **14** of base plate **6** and between the flat free end **8** of sidewall **5** of housing cover **4.** The water **15** is discharged through the opening **11** and does not affect the electronics **2.**

**Figure 14** is a sectional view of a further embodiment of the free end **8** of sidewall **5** of housing cover **4.** Here, a groove **13** is formed in the flat free end **8** of sidewall **5.** Groove **13** and the remainder of the flat portion of the free end **8** are located above the opening **11** in base plate **6.** The formation of groove **13** in the peripheral profile **12** of the free end **8** of housing cover **4** causes the water **15** to collect directly above the opening **11.** In this way, groove **13** forms a buffer that slows down water jet **16** so that it falls faster through oblong opening **11.**

It is believed that the present disclosure and many of its attendant advantages will be understood by the foregoing description, and it will be apparent that various changes may be made in the form, construction, number and arrangement of the components without departing from the disclosed subject matter or without sacrificing all of its material advantages. The form described is merely explanatory, and it is the intention of the following claims to encompass and include such changes. Accordingly, the scope of the invention should be limited only by the claims appended hereto.

### LIST OF REFERENCE NUMERALS

- 1: Electronic circuitry assembly
- 2: Electronics
- 3: Housing
- 4: Housing cover
- 5: Sidewall
- 6: Base plate
- 7: Gap
- 8: Free end
- 9: Outer reinforcement rib
- 10: Inner surrounding rim
- 11: Opening
- 12: Peripheral profile
- 13: Groove
- 14: Top side
- 15: Water
- 16: Water jet
- 17: Water flow
- 18: Capillary effect
- 19: Water discharge
- 20: Length, diameter
- 21: Effective length
- 22: Rounded end shape
- 23: Drop
- 100: Electronic control unit (ECU)

## Claims

1. A housing (3) for an electronic circuitry assembly (1);
the housing (3) being defined by a housing cover (4) and a base plate (6);
the base plate (6) having at least two outer reinforcement ribs (9) at an inner surrounding rim (10);
a surrounding sidewall (5) of the housing cover (4) sitting with a free end (8) of the surrounding sidewall (5) on the base plate (6) between the at least two outer reinforcement ribs (9) and the inner surrounding rim (10), thereby defining a gap (7) between the free end (8) of the surrounding sidewall (5) on the base plate (6);
**characterized by**
a plurality of openings (11) formed in the base plate (6);
the openings (11) being placed between the at least two outer reinforcement ribs (9) and the inner surrounding rim (10) of the base plate (6); and
the free end (8) of the surrounding sidewall (5) covering the openings (11) at least partially.

2. The housing (3) as claimed in claim 1, wherein the openings (11) are distributed around the inner surrounding rim (10) of the base plate (6).

3. The housing (3) as claimed in any one of the preceding claims, wherein the free end (8) of the surrounding sidewall (5) has a peripheral profile (12).

4. The housing (3) as claimed in claim 3, wherein the peripheral profile (12) is plain.

5. The housing (3) as claimed in claim 3, wherein the peripheral profile (12) has a groove (13) formed therein.

6. The housing (3) as claimed in any one of the preceding claims, wherein the openings (11) are formed by a punching process.

7. The housing (3) as claimed in any one of the preceding claims, wherein the openings (11) have an oblong form.

8. The housing (3) as claimed in any one of the preceding claims 1 to 6, wherein the openings (11) have a rectangular form.

9. The housing (3) as claimed in any one of the preceding claims 1 to 6, wherein the openings (11) have a round form.

10. The housing (3) as claimed in any one of the preceding claims, wherein the electronic circuitry assembly (1) is an electronic control unit (100).
